# EUROPEAN PATENT APPLICATION

(11) **EP 2 360 734 A2**
(43) Date of publication of application: **24.08.2011**
(21) Application number: 09827672.8
(22) Date of filing: 14.10.2009
(51) Int. Cl.: H01L 31/042

(54) **SILICON SUBSTRATE FOR SOLAR BATTERY, MANUFACTURING APPARATUS THEREOF, MANUFACTURING METHOD THEREOF, AND SOLAR BATTERY**

(30) Priority: 22.11.2008 KR 20080116536
(71) Applicant: Park, Rin Soon, Gyeonggi-do 421-201 (KR); Choi, Myung Hwa, Gyeonggi-do 421-201 (KR)
(72) Inventor: Park, Rin Soon, Gyeonggi-do 421-201 (KR); Choi, Myung Hwa, Gyeonggi-do 421-201 (KR)
(74) Representative: Pulieri, Gianluca Antonio
(86) International application number: PCT/KR2009/005912
(87) International publication number: WO 2010/058907

(57) **Abstract**

The present invention relates to a silicon substrate 10 for a solar battery, wherein the silicon substrate 10 comprises: a plurality of curves 13 constituted by concave parts 11 and convex parts 12 to absorb sunlight; and planes 14 connected to both edges of the curves to absorb sunlight and to be connected to other silicon substrates. Each of the curves 13 and each of the planes 14 have a thickness of 100 to 300µm, and each of the concave parts 11 or each of the convex parts 12 has a semi-circular shape. The curves 13 occupy 90% or more of the total area.

## Description

### [Technical Field]

The present invention relates to a silicon substrate for a solar battery, a manufacturing apparatus thereof, a manufacturing method thereof and a solar battery, and more particularly, to a silicon substrate for a solar battery, a manufacturing apparatus thereof, a manufacturing method thereof and a solar battery in which a surface area for absorbing sunlight increases compared to an installation area.

### [Background Art]

In recent years, researches and development for efficiency of solar batteries have been actively conducted. The representative technology for improving the efficiency of solar batteries is disclosed in Korean Patent No. 10-741306 "High Efficiency Solar Battery and Manufacturing Method thereof". The conventional solar battery has a flat type silicon substrate in which an installation area and a surface area for absorbing sunlight are almost the same and it is not easy to increase the absorption rate. Also, the silicon substrate has a thickness of 200 to 400µm to obtain a desired absorption rate, which raises manufacturing cost. As the silicon substrate is a flat type, it absorbs only a part of a particular wavelength among sunlight consisting of various wavelengths, and reflects the remaining wavelengths or has such wavelengths penetrate the silicon substrate, and thus the absorption rate of sunlight is low.

### [Disclosure]

### [Technical Problem]

The present invention has been made to solve the problems and it is an object of the present invention to provide a silicon substrate for a solar battery in which planes and curves are provided consistently and which enlarges the surface area for absorbing sunlight compared to an installation area to drastically raise the absorption rate of sunlight.

Another aspect of the present invention is to provide a silicon substrate for a solar battery which enlarges a surface area for absorbing sunlight and maintains a higher absorption rate with a 1/2 thickness (100 to 300µm) to thereby drastically reduce manufacturing cost.

Further, another aspect of the present invention is to provide a silicon substrate for a solar battery in which planes and curves are provided consistently and a part of reflected sunlight consisting of various wavelengths is absorbed again by another surface to thereby raise the absorption rate.

Further, another aspect of the present invention is to provide a manufacturing apparatus and a manufacturing method by which a high quality silicon substrate for a solar battery is manufactured.

Further, another aspect of the present invention is to provide a solar battery which employs the foregoing silicon substrate for a solar battery.

### [Technical Solution]

In order to achieve the object of the present invention, a silicon substrate for a solar battery comprises a plurality of curves which comprises concave parts and convex parts to absorb sunlight; and planes which are connected to both edges of the plurality of curves, and absorb sunlight and are connected to other silicon substrates.

The silicon substrate has the curves and the planes whose thickness is 100 to 300µm, and concaves parts or convex parts shaped like a semi-circle, and the curves which occupy 90% or more of the entire area.

A radius of curvature of the curves is 1.0 to 1.5 time the width of the planes. A distance between the curves is 4 to 6 times the width of the planes. The radius of curvature of the curves is 1.2 time the width of the planes, and the distance between the curves is 4.8 times the width of the planes.

The radius of curvature of the curves is 0.5 to 0.75 time the width of the planes. The distance between the curves is 2 to 3 times the width of the planes. The radius of curvature of the curves is 0.6 time the width of the planes, and the distance between the curves is 2.4 times the width of the planes.

In order to achieve the object of the present invention, a silicon substrate for a solar battery comprises a plurality of curves which comprises concave parts and first planes to absorb sunlight; and second planes which are connected to both edges of the plurality of curves, and absorb sunlight and are connected to other silicon substrates.

The silicon substrate has the curves and the second planes whose thickness is 100 to 300µm, and concaves parts shaped like a semi-circle, and the curves which occupy 90% or more of the entire area.

A radius of curvature of the concave parts is 1.0 to 1.5 time the width of the planes. A distance between the curves is 4 to 6 times the width of the planes. The radius of curvature of the concave parts is 1.2 time the width of the planes, and the distance between the curves is 4.8 times the width of the planes.

In order to achieve the object of the present invention, a manufacturing apparatus for a silicon substrate for a solar battery which is used to manufacture a silicon substrate comprises a water tank to supply and discharge liquid; a plurality of wire driving shafts which is provided in an internal wall of the water tank, and tightly pulls and rotates wire saws w cutting the silicon substrate; a first driving/controlling means which is installed in an outside of the water tank and automatically drives and controls the plurality of wire driving shafts; an ingot loader which is installed in an inside of the water tank and loads an ingot which moves back and forth and up and down; and a second driving/controlling means which is installed in an outside of the water tank and automatically drives and controls the ingot loader.

The manufacturing apparatus further comprises vibration reducing bars which are installed between the plurality of wire driving shafts to reduce a vibration of the wire saws.

In order to achieve the object of the present invention, a manufacturing method for a silicon substrate comprises bonding and mounting a silicon ingot on an ingot loader; filling a water tank with liquid; processing the silicon ingot by a plurality of wire saws and making a plurality of silicon substrates; discharging the liquid from the water tank to the outside; and taking the plurality of silicon substrates out of the water tank and removing the bonding to obtain each piece of the silicon substrates.

In order to achieve the object of the present invention, a solar battery which comprises a silicon substrate to generate an electron-hole pair carrier from introduced sunlight, wherein the silicon substrate comprises a silicon substrate according to the present invention.

### [Advantageous Effect]

As described above, a silicon substrate for a solar battery according to the present invention has planes and curves which are provided consistently and enlarges a surface area for absorbing sunlight compared to an installation area to drastically raise the absorption rate of sunlight.

A silicon substrate for a solar battery according to the present invention enlarges a surface area for absorbing sunlight and maintains a higher absorption rate with a 1/2 thickness (100 to 300µm) to thereby drastically reduce manufacturing cost.

A silicon substrate for a solar battery according to the present invention has planes and curves which are provided consistently and allows a part of reflected sunlight consisting of various wavelengths to be absorbed again by another surface to thereby raise the absorption rate.

A manufacturing apparatus and a manufacturing method for a silicon substrate for a solar battery according to the present invention may manufacture a silicon substrate with curves as desired without difficulty.

A solar battery according to the present invention may employ the foregoing silicon substrate and improves absorption rate and reduces manufacturing cost.

### [Brief Description of Drawings]

FIG. 1 is a perspective view of a silicon substrate for a solar battery according an exemplary embodiment of the present invention.

FIG. 2 is a perspective view of a silicon substrate for a solar battery according another exemplary embodiment of the present invention.

FIG. 3 is a perspective view of a silicon substrate for a solar battery according another exemplary embodiment of the present invention.

FIG. 4 illustrates a photo which illustrates a wire saw enlarged by 100 times which is used to manufacture the silicon substrates in FIGS. 1 to 3.

FIGS. 5 to 8 illustrate a manufacturing apparatus and a manufacturing process of the silicon substrates in FIGS. 1 to 3.

FIGS. 9 and 10 are photos which illustrate a wire saw enlarged by 100 times which is used to cut a silicon ingot used in manufacturing a silicon substrate.

### [Best Mode]

Hereinafter, a silicon substrate for a solar battery according to exemplary embodiments of the present invention will be described in detail with reference to accompanying drawings.

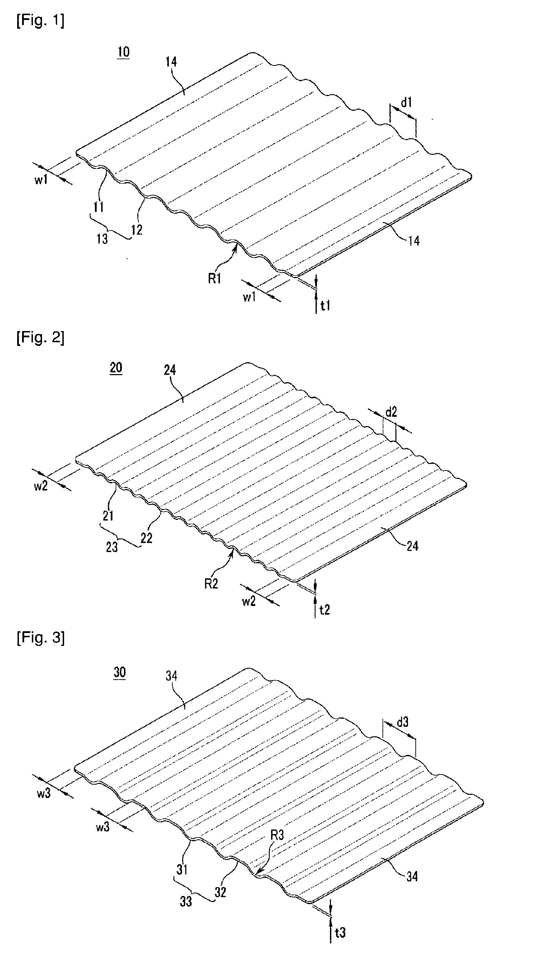

FIG. 1 is a perspective view of a silicon substrate according to an exemplary embodiment of the present invention.

As shown therein, a silicon substrate for a solar battery 10 according to the present exemplary embodiment includes a plurality of curves 13 including concave parts 11 and convex parts 12, and planes 14 connected to both edges of the curves 13. The curves 13 absorb sunlight, and the planes 14 absorb sunlight and connect silicon substrates. The silicon substrate 10 is manufactured to have a uniform thickness of 100 to 300µm, which is 1/2 of a thickness of a conventional substrate.

The silicon substrate 10 according to the present exemplary embodiment has the curves 13 shaped like a semi-circle and occupy 90% or more of the total area. A radius of curvature R1 of the curves 13 is 1.0 to 1.5 time, and preferably, 1.2 times the width w1 of the planes 14. A distance d1 between the curves 13 is 4 to 6 times, and more preferably, 4.8 times the width w1 of the planes 14.

Each edge of the silicon substrate 10 is chamfered as shown in FIG. 1.

FIG. 2 is a perspective view of a silicon substrate according to another exemplary embodiment of the present invention.

As shown therein, a silicon substrate for a solar battery 20 according to the present exemplary embodiment includes a plurality of curves 23 including concave parts 21 and convex parts 22, and planes 24 which are connected to both edges of the curves 23. The curves 23 absorb sunlight and the planes 24 absorb sunlight and connect other silicon substrates. The silicon substrate 20 has a uniform thickness of 100 to 300µm, which is 1/2 of a thickness of a conventional substrate.

The silicon substrate 20 according to the present exemplary embodiment has the curves 23 shaped like a semi-circle and occupy 90% or more of the total area. A radius of curvature R2 of the curves 23 is 0.5 to 0.75 time, and more preferably, 0.6 time the width w2 of the planes 24. A distance d2 between the curves 13 is 2 to 3 times, and more preferably, 2.4 times the width w2 of the planes 24.

Each edge of the silicon substrate 20 is chamfered as shown in FIG. 2.

FIG. 3 is a perspective view of a silicon substrate according to another exemplary embodiment of the present invention.

As shown therein, a silicon substrate for a solar battery 30 according to the present exemplary embodiment includes a plurality of curves 33 including concave parts 31 and convex parts 32, and planes 34 which are connected to both edges of the curves 33. The curves 33 absorb sunlight and the planes 34 absorb sunlight and connect other silicon substrates. The silicon substrate 30 has a uniform thickness of 100 to 300µm, which is 1/2 of a thickness of a conventional substrate.

The silicon substrate 30 according to the present exemplary embodiment has the curves 33 shaped like a semi-circle and occupy 90% or more of the total area. A radius of curvature R3 of the curves 33 is 1.0 to 1.5 time, and more preferably, 1.2 time the width w3 of the planes 34. A distance d3 between the curves 33 is 4 to 6 times, and more preferably, 4.8 times the width w3 of the planes 34. The width of the planes 32 is the same.

Each edge of the silicon substrate 20 is chamfered as shown in FIG. 3.

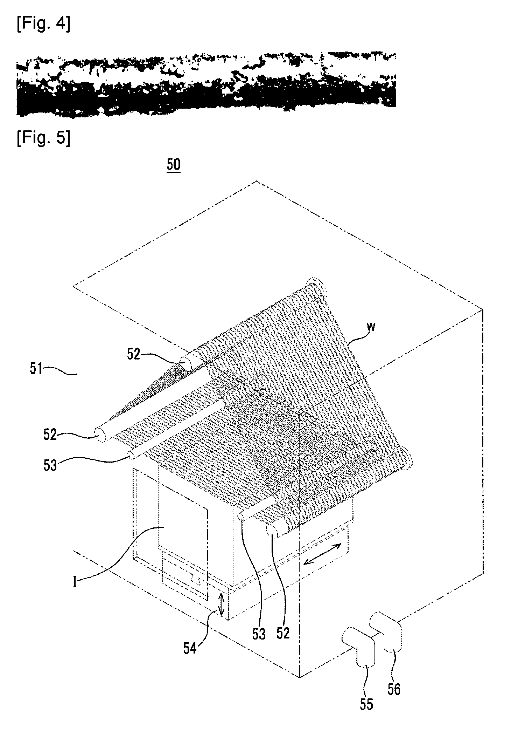

FIG. 4 illustrates a wire saw which is used to process the silicon substrates according to the foregoing exemplary embodiments.

FIG. 4 illustrates the wire saw which is enlarged by 100 times, and the wire saw is manufactured by fixing diamond particles with a diameter of 10 to 20µm to a wire surface with a diameter of 0.12mm.

FIGS. 5 to 8 illustrate a manufacturing apparatus and a manufacturing method for the silicon substrates according to the foregoing exemplary embodiments.

As shown therein, a manufacturing apparatus for a silicon substrate 50 includes a water tank 51 which stores therein liquid such as water at normal temperature or oil.

Wire driving shafts 52 are arranged in triangle in an internal wall of the water tank 51 to tightly pull and rotate wires saws w in FIG 4 clockwise or counterclockwise. The three wire driving shafts 52 are automatically driven and controlled by a first driving/control means (not shown) which is provided outside of the water tank 51.

Two vibration reducing bars are spaced from each other between the two wire driving shafts 52 provided in the same plane below among the three wire driving shafts 52 to reduce the vibration of the wire saws w. The bottom surface of the vibration reducing bars 53 slightly contacts the wire saws w.

In a bottom of the water tank 51, an ingot loader 54 is installed which moves back and force and up and down as shown in the drawings. An ingot I which is processed by the manufacturing apparatus 50 according to the present exemplary embodiment has a size of 156mm x 156mm x 250mm. The size of the ingot I may be changed depending on the change of the manufacturing apparatus.

An entrance door which is automatically driven and controlled is installed in a front wall of the water tank 51 so that the ingot I and the ingot loader 54 may enter the water tank 51 freely. The ingot loader 54 is automatically driven and controlled by a second driving/controlling means (not shown) which is provided in the outside of the water tank 51.

A supply part 55 which is used to supply liquid to the inside of the water tank 51 and a discharging part 56 which discharges the liquid from the water tank 51 are provided in a lateral wall of the water tank 51.

Next, a manufacturing process for a silicon substrate by using the above manufacturing apparatus 50 according to the present invention will be described.

As shown in FIG. 5, the ingot I is bonded and fixed to the ingot loader 54. In this case, the entrance door which is provided in the water tank 51 is open and the ingot loader 54 comes out of the water tank 51 and the ingot I is bonded and mounted on the ingot loader 54. Then, the ingot loader 54 goes inside the water tank 51 again and the entrance door is closed.

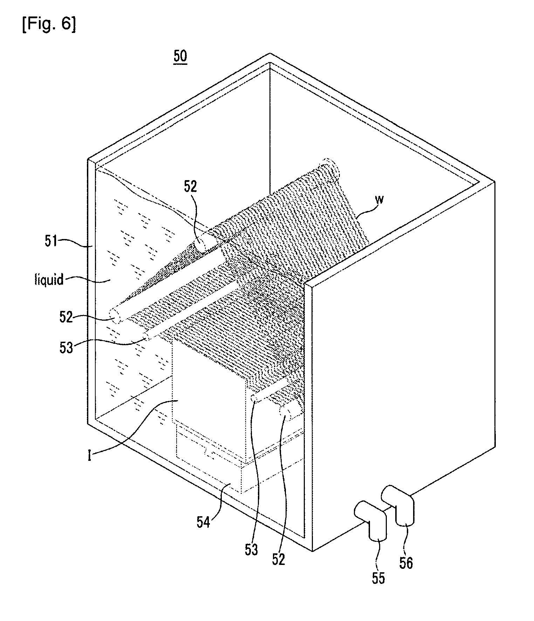

As shown in FIG. 6, the water tank 51 is filled with liquid sufficiently. The liquid is supplied through the supply part 55 from an external liquid storage tank, and the liquid is supplied enough to sink the upper wire driving shaft 52.

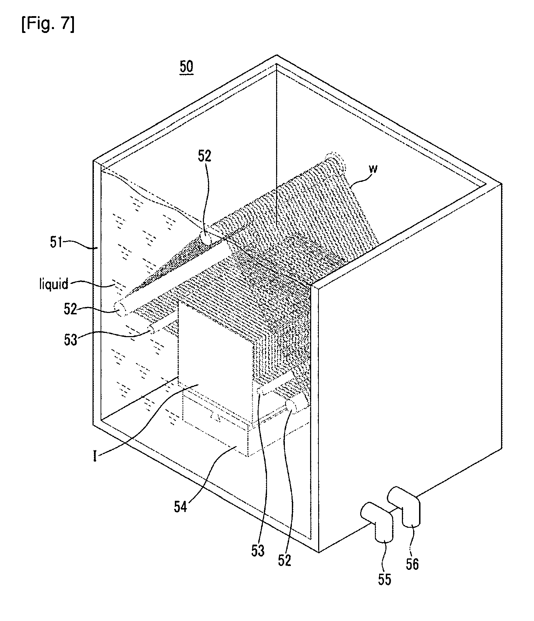

As shown in FIG. 7, the ingot I is processed by the wire saws w to manufacture a silicon substrate S. The ingot I is cut vertically by a plurality of wire saws w, and curves as in FIGS. 1 to 3 may be formed as the ingot loader 54 mounting the ingot I thereon may move to the left and right. As shown in FIG. 5, as the ingot I moves upwards while the wire saws w are fixed, the ingot I is cut vertically and the silicon substrate has curves and planes as the ingot I moves to the left or right.

The rotation of the wire saws w in a clockwise or counterclockwise direction is automatically driven and controlled by the first driving/controlling means. As described above, the selective left and right movement of the ingot loader 54 may be automatically driven and controlled by the second driving/controlling means.

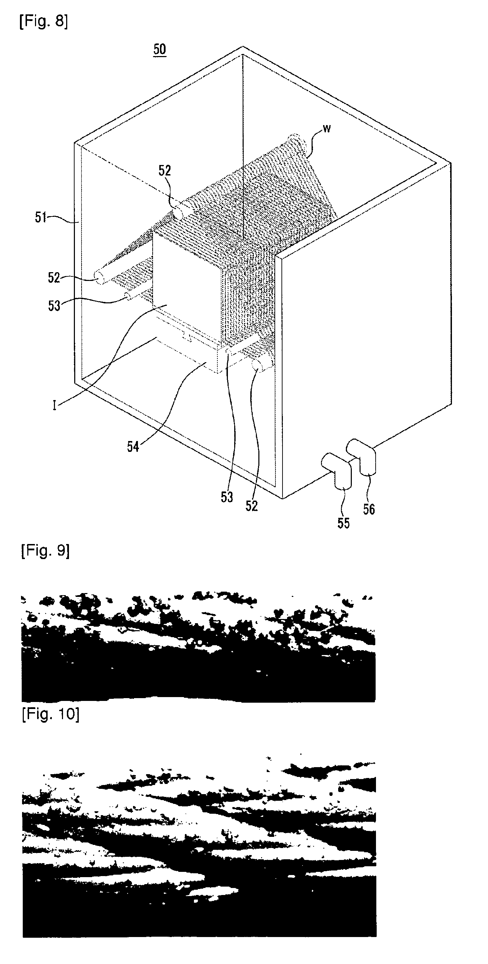

As shown in FIG. 8, the liquid which is stored in the water tank 51 is discharged to the outside. The liquid is discharged to the outside through the discharging part 56, which is performed automatically.

Lastly, the obtained silicon substrate S is taken out of the water tank 51 and the bonding is removed therefrom to obtain each piece of the silicon substrate S.

A large lump of the silicon ingot which is shaped like a rectangular parallelepiped and used for the foregoing apparatus and method is obtained by the wire saws shown in FIG. 9 or 10.

FIGS. 9 and 10 illustrate wire saws which are enlarged about 100 times for reference.

As shown in FIG. 9, six thin wire saws with a diameter of approximately 0.8mm surround one thin central wire saw with a diameter of about 0.8mm, and diamond particles with a diameter of 25 to 45µm are fixed around an external circumference. The diameter of the obtained wire saw is about 0.85 to 0.9mm.

As shown in FIG. 10, among seven thick wire saws which are made by thin wire saws with a diameter of approximately 2.1mm surrounding one thin wire saw with a diameter of about 2.1mm, one thick wire saw is provided in the middle and six wire saws are provided in a circumference thereof. Diamond particles with a diameter of 25 to 100µm are fixed around an external circumference. The diameter of the obtained wire saw is about 2.15 to 2.3mm.

The silicon substrate which is manufactured as above may be formed with a conductive line to make a solar battery. Based on the solar battery according to the present invention, various products may be manufactured as desired by a designer.

Although a few exemplary embodiments have been shown and described, it will be appreciated by those skilled in the art that changes may be made in these exemplary embodiments without departing from the principles and spirit of the invention, the range of which is defined in the appended claims and their equivalents.

## Claims

1. A silicon substrate for a solar battery comprising:
a plurality of curves which comprises concave parts and convex parts to absorb sunlight; and
planes which are connected to both edges of the plurality of curves, and absorb sunlight and are connected to other silicon substrates.

2. The silicon substrate according to claim 1, wherein a thickness of the curves and the planes is 100 to 300µm.

3. The silicon substrate according to claim 1, wherein the concaves parts or convex parts are shaped like a semi-circle, and the curves occupy 90% or more of the entire area.

4. A silicon substrate for a solar battery comprising:
a plurality of curves which comprises concave parts and first planes to absorb sunlight; and
second planes which are connected to both edges of the plurality of curves, and absorb sunlight and are connected to other silicon substrates.

5. The silicon substrate according to claim 4, wherein a thickness of the curves and the second planes is 100 to 300µm.

6. The silicon substrate according to claim 4, wherein the concaves parts are shaped like a semi-circle, and the curves occupy 90% or more of the entire area.

7. A manufacturing apparatus for a silicon substrate for a solar battery which is used to manufacture a silicon substrate according to one of claims 1 to 6, wherein the apparatus comprises a water tank to supply and discharge liquid;
a plurality of wire driving shafts which is provided in an internal wall of the water tank, and tightly pulls and rotates wire saws w cutting the silicon substrate;
a first driving/controlling means which is installed in an outside of the water tank and automatically drives and controls the plurality of wire driving shafts;
an ingot loader which is installed in an inside of the water tank and loads an ingot which moves back and forth and up and down; and
a second driving/controlling means which is installed in an outside of the water tank and automatically drives and controls the ingot loader.

8. The manufacturing apparatus according to claim 7, further comprising vibration reducing bars which are installed between the plurality of wire driving shafts to reduce a vibration of the wire saws.

9. A manufacturing method for a silicon substrate according to one of claims 1 to 6 by using the apparatus according to claim 7 or 8, the method comprising:
(A) bonding and mounting a silicon ingot on an ingot loader;
(B) filling a water tank with liquid;
(C) processing the silicon ingot by a plurality of wire saws and making a plurality of silicon substrates;
(D) discharging the liquid from the water tank to the outside; and
(E) taking the plurality of silicon substrates out of the water tank and removing the bonding to obtain each piece of the silicon substrates.

10. A solar battery which comprises a silicon substrate to generate an electron-hole pair carrier from introduced sunlight, wherein the silicon substrate comprises a silicon substrate according to one of claims 1 to 6.
